# EUROPEAN PATENT SPECIFICATION

(11) **EP 3 281 730 B1**
(45) Date of publication and mention of the grant of the patent: **29.12.2021**
(21) Application number: 17181753.9
(22) Date of filing: 17.07.2017
(51) Int. Cl.: B22D 23/06, B22D 27/04, B22F 5/00, B22F 5/04, C30B 11/00, C30B 29/52, B22F 10/64, B33Y 10/00, B33Y 30/00, B22F 10/20, B33Y 40/20, B22F 3/24

(54) **SYSTEM AND METHOD FOR FORMING DIRECTIONALLY SOLIDIFIED PART FROM ADDITIVELY MANUFACTURED ARTICLE**
SYSTEM UND VERFAHREN ZUR HERSTELLUNG EINES GERICHTET ERSTARRTEN TEILS EINES GENERATIV GEFERTIGTEN ARTIKELS
SYSTÈME ET PROCÉDÉ DE FORMATION D'UNE PIÈCE À SOLIDIFICATION DIRECTIONNELLE À PARTIR D'UN ARTICLE FABRIQUÉ DE MANIÈRE ADDITIVE

(30) Priority: 08.08.2016 US 201615231377
(43) Date of publication of application: 14.02.2018
(73) Proprietor: Honeywell International Inc., Morris Plains, NJ 07950 (US)
(72) Inventor: MITTENDORF, Don, Morris Plains, NJ 07950 (US); BUI, Tho X., Morris Plains, NJ 07950 (US); OTALUKA, Will, Morris Plains, NJ 07950 (US); MARTINEZ, Edwin, Morris Plains, NJ 07950 (US); WOODWORD, John, Morris Plains, NJ 07950 (US); KASAL, Yathiraj, Morris Plains, NJ 07950 (US)
(74) Representative: LKGlobal UK Ltd.

(56) References cited:
- EP-A1- 0 092 496
- EP-A1- 2 792 771
- EP-A1- 2 947 184
- US-A1- 2015 290 707

## Description

### TECHNICAL FIELD

The present disclosure generally relates to directional solidification methods and systems and, more particularly, relates to a system and method for forming a directionally solidified part from an additively manufactured article.

### BACKGROUND

Parts may be made in a controlled manner to have one or more material characteristics. For example, it may be beneficial for a gas-turbine engine to have parts made from a material relatively free from impurities. Also, it may be beneficial for these parts to have a crystal structure with relatively few grain boundaries (e.g., with a single-crystal structure). Such parts may increase the efficiency and/or the operating life of the engine.

Manufacture of such parts may be difficult, expensive, time consuming, or otherwise problematic. For example, casting processes may be employed when manufacturing these parts. However, formation of the casting may present problems, especially when the part to-be-formed (e.g., a turbine blade, nozzle, or other component of a gas-turbine engine) has complex geometry. EP2792771 A1 and EP2947184 A1 disclose forming single crystal turbine components by additive manufacturing.

The present disclosure relates to an efficient method and system for forming directionally solidified (DS) parts from an additively manufactured article. The method/system may be used to form parts with single-crystal structure in some embodiments. The method and system may facilitate and expedite manufacture, and the method and system may reduce costs as compared to the prior art. Furthermore, other desirable features and characteristics of the present disclosure will become apparent from the subsequent detailed description and the appended claims, taken in conjunction with the accompanying drawings and the foregoing technical field and background.

### BRIEF SUMMARY

The present invention is defined by the appended claims.

In the present disclosure, a method of manufacturing a directionally solidified article includes providing a collection of particulate material and additively manufacturing a first article with an outer wall from the particulate material. The outer wall defines at least part of a cavity. The cavity contains an amount of the particulate material. The method also includes encasing at least a portion of the first article with an outer member. The outer member defines an internal cavity that corresponds to the first article. The method further includes heating the outer member and the first article to melt the first article into a molten mass within the internal cavity of the outer member. Additionally, the method includes solidifying the molten mass along a predetermined solidification path within the outer member to form a second article that corresponds to at least a portion of the internal cavity of the outer member.

In another aspect, a manufacturing system for manufacturing a directionally solidified article of the present disclosure includes an additive manufacturing device having a support that is configured support a collection of particulate material. The additive manufacturing machine is configured to additively manufacture a first article with an outer wall from the particulate material. The outer wall defines at least part of a cavity, and the cavity contains an amount of the particulate material. The manufacturing system also includes an encasement device configured to form an outer member about at least a portion of the first article. The outer member defines an internal cavity that corresponds to the at least a portion of the first article. The manufacturing system further includes a heating device configured to heat the outer member and the first article to melt the first article into a molten mass within the internal cavity of the outer member. Moreover, the manufacturing system includes a solidification device configured to solidify the molten mass along a predetermined solidification path within the outer member to form a second article that corresponds to at least a portion of the internal cavity of the outer member.

In another aspect, a method of manufacturing an article with a single-crystal structure of the present disclosure includes providing a collection of particulate material. The method further includes additively manufacturing a first article with an outer wall from the particulate material. The first article includes a main body portion and a sprue portion. The sprue portion extends helically about a longitudinal axis. The outer wall defines a cavity that fully encapsulates and contains an amount of the particulate material. The amount of particulate material occupies a majority of the cavity. The method additionally includes fully encasing the first article with an outer member. The outer member defines an internal cavity that corresponds to the first article. Moreover, the method includes heating the outer member and the first article to melt the first article into a molten mass within the internal cavity of the outer member. Also, the method includes solidifying the molten mass along a predetermined solidification path within the internal cavity of the outer member to form a second article with a first portion that corresponds to the main body portion and a trim portion that corresponds to the sprue portion. The second article has a single-crystal structure. Furthermore, the method includes removing the second article from the internal cavity and removing the trim portion from the first portion.

### BRIEF DESCRIPTION OF THE DRAWINGS

The present disclosure will hereinafter be described in conjunction with the following drawing figures, wherein like numerals denote like elements, and wherein:
FIG. 1A is a perspective view of an example part formed according to a manufacturing method of the present disclosure;
FIG. 1B is a schematic perspective view of the part according to additional embodiments of the present disclosure;
FIG. 2 is a functional block diagram of a manufacturing system configured to form the part of FIG. 1A and/or FIG. 1B;
FIG. 3 is a flowchart illustrating a method of manufacturing the part of FIG. 1A and/or FIG. 1B;
FIG. 4 is a schematic side view of an additive manufacturing device, which is part of the manufacturing system of FIG. 2, and which is used in the manufacturing method of FIG. 3;
FIG. 5 is a section view of a part that is additively manufactured using the additive manufacturing device of FIG. 4, wherein the section of FIG. 5 is taken along the line 5-5 of FIG. 4;
FIG. 6 is a detail view of a collection of particulate material of the additive manufacturing device of FIG. 4;
FIG. 7 is a schematic side view of an encasement device, which is part of the manufacturing system of FIG. 2, and which is used in the manufacturing method of FIG. 3;
FIG. 8 is a schematic side view of a heating device, which is part of the manufacturing system of FIG. 2, and which is used in the manufacturing method of FIG. 3;
FIG. 9 is a schematic side view of a solidification device, which is part of the manufacturing system of FIG. 2, and which is used in the manufacturing method of FIG. 3;
FIG. 10 is a schematic side view of a post-solidification device, which is part of the manufacturing system of FIG. 2, and which is used in the manufacturing method of FIG. 3; and
FIG. 11 is a flowchart illustrating the method of the present disclosure according to additional embodiments; and
FIG. 12 is an exploded perspective view of an additively manufactured article used in the method of FIG. 11 according to exemplary embodiments of the present disclosure.

### DETAILED DESCRIPTION

The following detailed description is merely exemplary in nature and is not intended to limit the present disclosure or the application and uses of the present disclosure. Furthermore, there is no intention to be bound by any theory presented in the preceding background or the following detailed description.

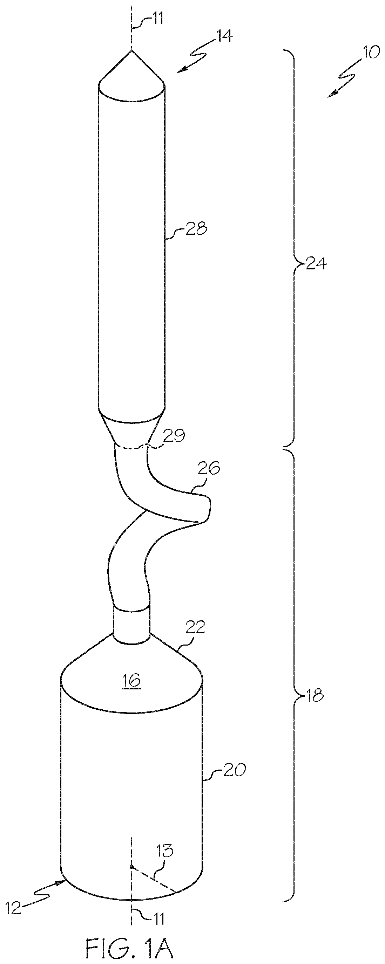

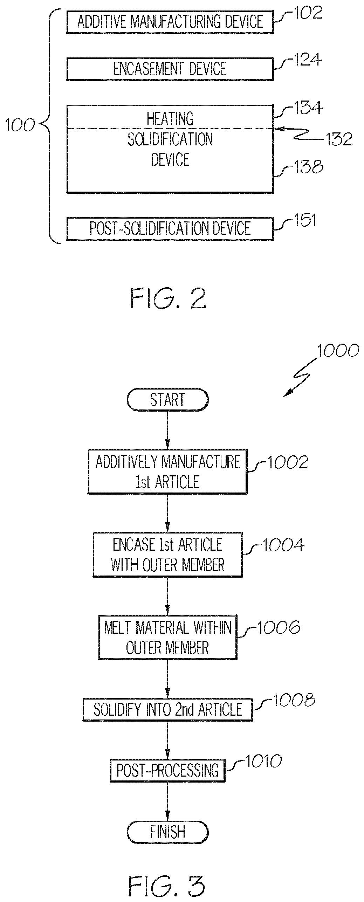

Referring initially to FIG. 1A, a part 10 is shown according to exemplary embodiments of the present disclosure. The part 10 may be formed using the system 100 represented schematically in FIG. 2 and according to the manufacturing method 1000 represented in FIG. 3.

As will be discussed, the part 10 may be formed in a specific and controlled manner. For example, the part 10 may be solidified from a molten material in a predetermined manner. For example, in some embodiments, the part 10 may be directionally solidified as will be discussed in detail below. Accordingly, the material structure of the part 10 may include relatively few crystals and/or relatively few grain boundaries. Specifically, in some embodiments, the part 10 may have a single-crystal grain structure. The part 10 may be manufactured with the system 100 of FIG. 2 and/or the method 1000 of FIG. 3. Accordingly, as will be discussed, the part 10 may be formed in an efficient and effective manner.

It will be appreciated that the terms "directionally solidified," "directional solidification," and other related terms are used generally herein to include solidification that occurs in a predetermined and controlled manner, and substantially along a predetermined direction. Thus, directional solidification methods of the present disclosure may be used to form a part with single-crystal grain structure in some embodiments. In other embodiments, directional solidification methods of the present disclosure may be used to form a part with multiple-crystal grain structure.

Referring now to FIG. 1A, specific features of the part 10 will be discussed in greater detail. The part 10 may be a one-piece, unitary body. The part 10 may be substantially solid (i.e., not hollow). In additional embodiments, the part 10 may include one or more internal channels, flow passageways, pockets, etc. The part 10 may define a longitudinal axis 11 and a radial axis 13. The part 10 includes a first end 12 and a second end 14, which are spaced apart relative to the longitudinal axis 11. The part 10 also includes an outer periphery 16 (i.e., outer surface).

As shown, the part 10 may include a first body portion 18 and a second body portion 24, which are joined end-to-end at an imaginary parting plane 29. The first body portion 18 may include a cylindrical portion 20, a frusto-conic portion 22, and a helical member 26. The first body portion 18 may also be referred to as a sprue portion. The cylindrical portion 20 and frusto-conic portion 22 may be substantially centered about the longitudinal axis 11. The frusto-conic portion 22 may be disposed on an end of the cylindrical portion 20, opposite the first end 12 of the part 10. The helical member 26 may extend helically about the longitudinal axis 11 as it extends away from the frusto-conic portion 22. The second body portion 24 may include a cylindrical portion 28 that is centered on the longitudinal axis 11. The second body portion 24 may also be tapered at the second end 14.

It will be appreciated that the part 10 shown in FIG. 1A is merely an example of a variety of parts that may be manufactured using the system 100 of FIG. 2 and/or the method 1000 of FIG. 3. Thus, the shape, dimensions, or other features of the part 10 may differ from the embodiment shown in FIG. 1A without departing from the scope of the present disclosure.

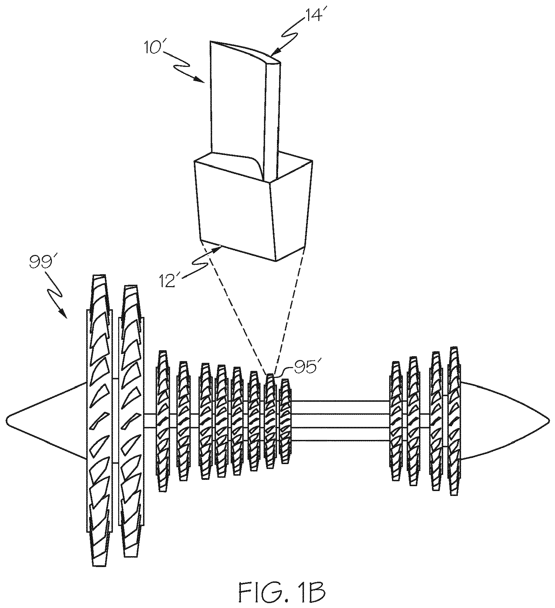

The shape, dimensions, etc. of the part may be specifically designed according to its use. For example, as shown in FIG. 1B, the part 10' is shown according to additional embodiments. The part 10' is configured for use within a gas-turbine engine 99', such as an engine of an aircraft. Accordingly, the first end 12' may be configured for attachment to a rotor 95' of the engine 99', and the second end 14' may be contoured for directing gas flow past the rotor 95' during operation of the engine 99'.

The part 10, 10' may be formed and shaped for other uses as well without departing from the scope of the present disclosure. For example, the part 10, 10' may be formed and shaped for use as a nozzle or other component of the gas-turbine engine 99' or for other uses.

The part 10, 10' may also include features specifically for use during manufacturing. For example, the part 10, 10' may include a sprue, a chiller plate, or other features used in casting or casting-type operations.

The part 10, 10' may be made out of any suitable material. For example, in some embodiments, the part 10, 10' may be made out of a material configured for additive manufacturing. For example, the material may be suitable for a 3-D printing process.

Also, the material of the part 10, 10' may have certain temperature-dependent characteristics, such as a predetermined melting point. If the material is heated above this point, the material melts and becomes liquid, flowable, molten, etc. If the material is cooled below this point, the material solidifies and becomes solid, hardens, etc. In some embodiments, the material may be specifically configured for being melted, then solidified, then re-melted in a sequence.

Furthermore, the material may be configured for solidification along a predetermined solidification path. For example, the part 10, 10' may be formed from material useful in a directional solidification process.

Once solidified, the part 10, 10' may have a material structure with a relatively low number of crystals and/or internal grain boundaries. For example, in some embodiments, the majority of the part 10, 10' may have a single-crystal grain structure. Additionally, in some embodiments, all or substantially all of the part 10, 10' may have a single-crystal grain structure. In other words, all or substantially all of the part 10, 10' may be made from a single crystal of material. In addition, the part 10, 10' may have a material structure with relatively few voids or cavities. Also, any voids or cavities that are included in the part 10, 10' may be relatively small.

The following will provide further details of the present disclosure in reference to the part 10 of FIG. 1A. However, it will be appreciated that the following may apply as well to the part 10' of FIG. 1B or to another part without departing from the scope of the present disclosure.

Referring now to FIG. 2, the system 100 for manufacturing the part 10 will be discussed in greater detail according to exemplary embodiments. Generally, the system 100 includes an additive manufacturing device 102, an encasement device 124, a heating/solidification device 132, and a post-solidification device 151. As shown in FIG. 2, the heating/solidification device 132 may be embodied by a single machine, which performs both heating and solidification functions. However, in other embodiments, heating may be performed by a single machine, and solidification may be performed by a different machine.

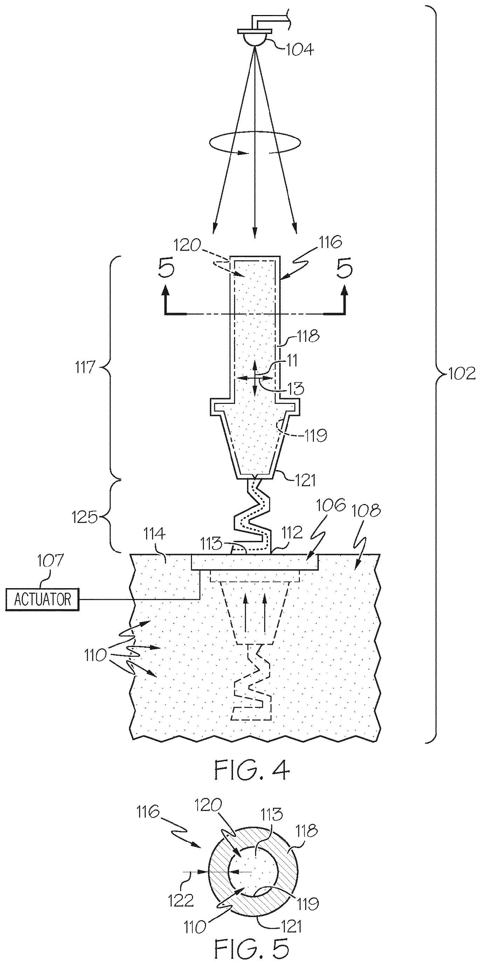

The system 100 is employed for performing the manufacturing method 1000 illustrated in FIG. 3. The method 1000 of FIG. 3 and the system 100 of FIG. 2 will now be discussed according to exemplary embodiments and in relation to FIGS. 4-10.

The method 1000 begins at 1002, wherein the additive manufacturing device 102 is used. The additive manufacturing device 102 may be a 3-D printer and/or include components that are common to a 3-D printer. The additive manufacturing device 102 is used to additively manufacture (e.g., 3-D print) a first article 116 as illustrated in FIG. 4. The first article 116 may correspond in shape substantially to the part 10 discussed above and illustrated in FIG. 1A. Thus, the first article 116 of FIG. 4 may be formed to include a first portion 125 corresponding to the first body portion 18 of the part 10 of FIG. 1A. Likewise the first article 116 of FIG. 4 may be formed to include a second portion 117 corresponding to the second body portion 24 of FIG. 1A.

The first article 116 is additively manufactured using any type of additive manufacturing process which utilizes layer-by-layer construction, including, but not limited to: selective laser melting; direct metal deposition; direct metal laser sintering (DMLS); direct metal laser melting; electron beam melting; electron beam wire melting; micro-pen deposition in which liquid media is dispensed with precision at the pen tip and then cured; selective laser sintering in which a laser is used to sinter a powder media in precisely controlled locations; laser wire deposition in which a wire feedstock is melted by a laser and then deposited and solidified in precise locations to build the product; laser engineered net shaping; Direct Metal Electron Beam Fusion (DMEBF); and other powder consolidation techniques. In one particular exemplary embodiment, direct metal laser fusion (DMLF) may be used to manufacture the first article 116. DMLF is a commercially available laser-based rapid prototyping and tooling process by which complex parts may be directly produced by precision melting and solidification of metal powder (the "build material") into successive layers of larger structures, each layer corresponding to a cross-sectional layer of the first article 116.

The additive manufacturing device 102 includes an emitter 104. The emitter 104 may emit a laser, an electron beam, or other energy toward a support bed 106. The support bed 106 may support a collection of material 108. A condition of the material 108 may change as a result of exposure to the laser, electron beam, etc. from the emitter 104. The support bed 106 may be connected to an actuator 107. The actuator 107 may selectively change elevation of the support bed 106. The first article 116 may be formed layer by successive layer as the actuator 107 moves the support bed 106 until the first article 116 is completed. In some embodiments, the emitter 104 and/or the actuator 107 may be in communication with a computerized device (not shown). The computerized device may include computerized memory (RAM or ROM) and a processor. The processor may send control signals to the emitter 104 and/or the actuator 107 based on CAD data that is stored in the memory. The CAD data can correspond to the first article 116. Accordingly, the processor may control the emitter 104 and/or the actuator 107 to form the first article 116.

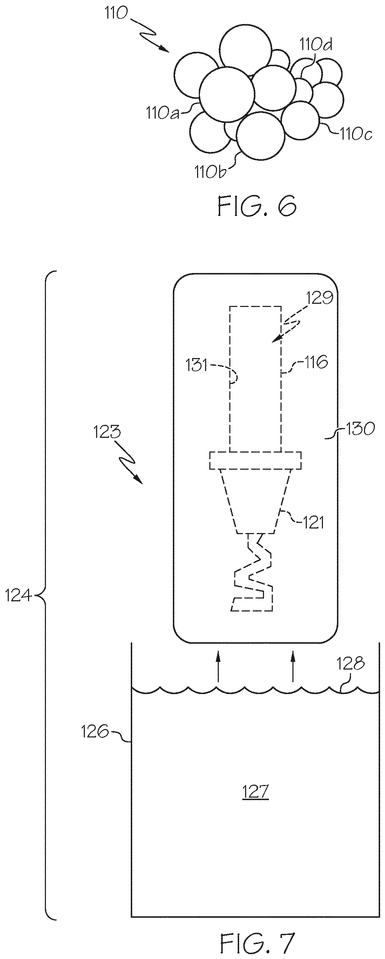

In the embodiments, the material 108 includes a plurality of particles 110. As shown in detail in FIG. 6, the particles 110 may include substantially spherical particles 110a, 110b, 110c, 110d of various sizes. However, it will be appreciated that the particles 110 may be of any shape and size. The particles 110 may be of single crystal material structure in some embodiments. Additionally, in some embodiments, the particles 110 may be made from a metal alloy or super alloy. In one example, the particles 110 may be made from a nickelbased super alloy, an iron-based super alloy, a cobalt-based super alloy, or combinations thereof. For example, the particles 110 may be made from SC180, CMSX-4, or another single crystal alloy.

The emitter 104 may emit focused energy at a first group 112 of particles 110, causing adjacent particles 110 within the first group 112 to melt and fuse together. The actuator 107 may simultaneously move the support bed 106 such that the first article 116 is formed layer-by-layer from the first group 112 of particles 110. An outer surface 121 of the first article 116 may substantially correspond in shape, scale, and dimension to the part 10 shown in FIG. 1A. Thus, the outer surface 121 may have at least one area that has complex curvature (i.e., three-dimensional contour). Once formed, the first article 116 may be supported atop the support bed 106 as shown.

In the embodiments, the first article 116 formed on the additive manufacturing device 102 is substantially hollow. For example, as shown in the cross section of FIG. 5, the first article 116 includes an outer wall 118 that extends about a cavity 120 of the first article 116. In other words, an inner surface 119 of the outer wall 118 defines the cavity 120. The longitudinal cross section of the cavity 120 is shown in phantom in FIG. 4. The outer wall 118 may be substantially consistent throughout the first article 116. In some embodiments, the thickness 122 of the outer wall 118 may be between approximately 0.076 mm (0.003 inches) and 0.79 mm (1/32 inches) in some embodiments. Also, in some embodiments, the outer wall 118 may extend continuously about the first article 116, forming a substantially complete enclosure in all directions.

In the embodiments, the outer wall 118 is formed out of some of the particles 110, and other particles 110 remain unaffected. The outer wall 118 is formed layer-by-layer such that those other, unaffected particles 110 are contained within the cavity 120. Stated differently, the outer wall 118 surrounds and at least partially encapsulates the particles within the cavity 120. As shown in FIGS. 4 and 5, the outer wall 118 contains a second group 113 of particles 110. The second group 113 of particles 110 may occupy a majority of the cavity 120. The second group 113 of particles 110 may fill substantially all of the cavity 120. However, the second group 113 of particles 110 are loosely packed within the cavity 120. The second group 113 of particles 110 are ultimately disposed within the cavity 120 due to the nature of the additive manufacturing process. Specifically, during the additive manufacturing process, the outer walls 118 are formed layer-by-layer around the second group 113 of particles 110 such that the outer wall 118 ultimately contains the second group 113 of particles 110. In other words, energy from the emitter 104 affects the first group 112 of particles 110 to form the outer wall 118 without affecting the second group 113 of particles 110 such that the outer wall 118 is formed around the second group 113 of particles 110. Likewise, a third group 114 of particles 110 (FIG. 4) remain unaffected by energy from the emitter 104 during the additive manufacturing process, and the third group 114 of particles 110 remain disposed outside the first article 116.

The first article 116 may have predetermined density and/or porosity characteristics. The outer wall 118 may have substantially high density and, thus, relatively low porosity. In contrast, the density of the second group 113 of particles 110 may be significantly lower than the density of the outer wall 118. Also, the porosity between the particles 110 within the second group 113 may be significantly higher than the porosity of the outer wall 118. By way of example, the outer wall 118 may have approximately 100% density and approximately 0% porosity, whereas the second group 113 of particles 110 may have approximately 65% density and approximately 35% porosity. In total, the density of the first article 116 (i.e., the density of the outer wall 118 and the second group 113 of particles 110 taken together) may be less than approximately 85%. Also, the porosity of the first article 116 may be greater than approximately 15%. These characteristics may provide certain benefits. For example, as will be explained in detail below, the material of the first article 116 is heated and cooled during the method 1000. Because the first article 116 has these predetermined density/porosity characteristics, the thermal expansion of the material of the first article 116 may be controlled.

Once the first article 116 is formed by the additive manufacturing process, with reference to FIG. 3, the method 1000 2. continues to 1004, wherein the first article 116 is encased by an outer member 130 as represented in FIGS. 3 and 7.

Specifically, the first article 116 may be transported to a container 126. The container 126 may contain a slurry 128 of outer member material 127. The outer member material 127 is a ceramic material in some embodiments. The outer member material 127 may be, for example, silica, alumina, zircon, cobalt, mullite, kaolin, and mixtures thereof. The outer member material 127 generally has a melting point that is greater than the melting point of the particles 110.

The first article 116 may be exposed to the outer member material 127, for example, by dipping the first article 116 into the outer member material 127, by spraying the outer member material 127 onto the first article 116, etc. In some embodiments, a relatively thin coating may be applied to the outer surface 121 of the first article 116 before exposure to the outer member material 127. For example, the first article 116 may be coated with an organic material (e.g., wax or varnish) or with an inert ceramic coating. The article 116 may be exposed to the slurry 128 repeatedly for as many times as necessary to form the outer member 130 with an acceptable thickness. The outer member material 127 may be cured about the first article 116 to form the outer member 130 with solid and rigid properties.

In some embodiments, the outer member 130 may encase an entirety of the first article 116, such that the entire outer surface 121 of the first article 116 is covered by the outer member 130 and an inner wall 131 of an internal cavity 129 substantially conforms to a shape of the first article 116. In other embodiments, the outer member 130 may partially encase the first article 116; however, the outer member 130 may encase a majority of the first article 116 in these embodiments. In these latter embodiments, the outer member 130 may be formed such that a portion of the first article 116 is exposed and/or protrudes from the outer member 130. Still further, the outer member 130 may be formed with at least one hole that exposes the first article 116.

Once hardened, the inner wall 131 corresponds to the outer surface 121 of the first article 116. Also, the outer member 130 contains the first article 116 as well as the second group 113 of particles 110 disposed within the first article 116. In other words, an encasement 123 may be formed. It will be appreciated that the encasement 123 includes the outer member 130 and any material contained within the internal cavity 129. Thus, in the embodiment of FIG. 7, the encasement 123 includes the outer member 130, the first article 116, as well as the second group 113 of particles 110 contained within the first article 116.

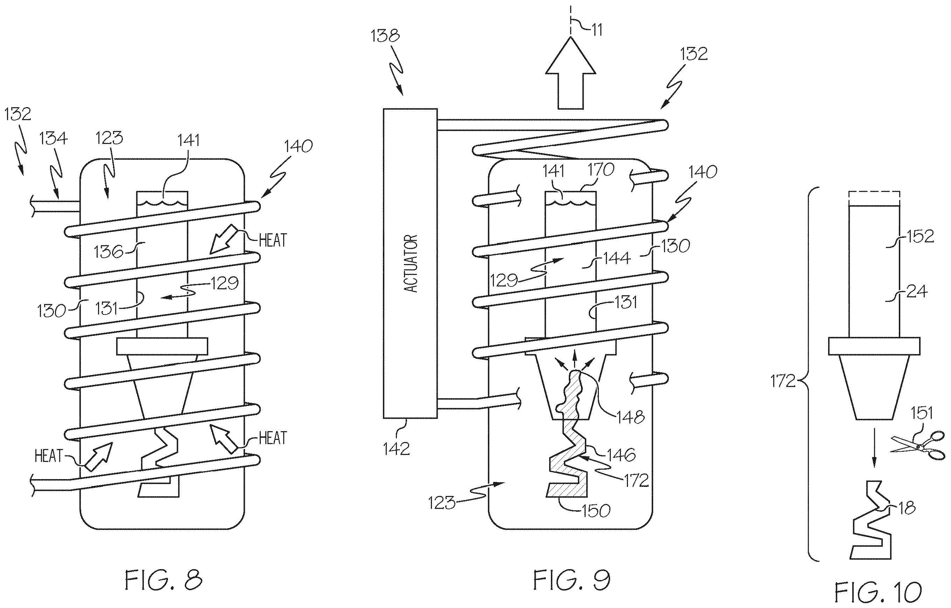

Next, the method 1000 continues at 1006, wherein the encasement 123 is transported to the heating/solidification device 132 represented in FIG. 8. In some embodiments, the heating/solidification device 132 may include a heating device 134. The heating element 140 is represented in FIG. 8 (and in FIG. 9) as extending helically about and surrounding the outer member 130. The heating element 140 may be an electrically resistive element that provides heat to the encasement 123 in some embodiments. Also, the heating element 140 may provide radiant heat, inductive heating, or another type. During operation, the heating element 140 provides heat to the outer member 130 as well as the material therein. The heating device 134 heats the encasement 123 to melt the material within the internal cavity 129, turning this material molten and flowable while the outer member 130 remains solid. Specifically, the material of the first article 116 as well as the second group 113 of particles 110 melt together to form a molten mass 136. The molten mass 136 may be contained by the inner wall 131 of the outer member 130. Additionally, if a coating was applied to the first article 116, that coating may evaporate and vent out of the outer member 130. Otherwise, the coating may become part of the outer member 130.

In some embodiments, the volume of the molten mass 136 may be less than the volume of the internal cavity 129. As discussed above, the first article 116 may contain the second group 113 of particles 110. Thus, the molten mass 136 may melt, and cause a pocket 141 to form within the cavity 129 as shown in FIG. 8. It will be appreciated that the material of the first article 116 may thermally expand as it melts into the molten mass 136. Therefore, the density and porosity of the first article 116 (described in detail above) may allow the material to thermally expand within the internal cavity 129 without damaging the outer member 130. In other words, there is enough room within the cavity 129 for the material to melt and thermally expand without damaging the outer member 130 because of the density and porosity characteristics of the first article 116.

Next, the method 1000 continues to 1008, and directional solidification processes (e.g., zone refinement processes) may be performed as represented in FIG. 9. In some embodiments, the heating element 140 may be used, in part, as a solidification device 138 for directionally solidifying the molten mass 136. The solidification device 138 may also include an actuator 142, which is operatively connected to the heating element 140. The actuator 142 may be a hydraulic actuator in some embodiments. Also, the actuator 142 may be a linear actuator in some embodiments. The actuator 142 may be configured to move the heating element 140 relative to the encasement 123. The actuator 142 may also be configured to move the encasement 123 relative to the heating element 140 in some embodiments. Specifically, as shown in the FIG. 9, the actuator 142 may move the heating element 140 relative to one end of the encasement 123, causing the molten mass 136 adjacent a sprue end 150 of the cavity 129 to cool initially. Accordingly, a zone of solidified material 146 forms. Additionally, in some embodiments, the process may include using a starter seed or grain selector to enable a single crystal to form. It will be appreciated that the leading edge 148 may be a barrier between the solidified material 146 and a remaining molten portion 144 of the molten mass 136.

The zone of solidified material 146 may grow and the leading edge 148 may proceed through the cavity 129, generally along the longitudinal axis 11 toward an opposing end 170 of the cavity 129. Also, the zone of solidified material 146 may grow until the molten mass 136 is fully solidified within the internal cavity 129. Once solidified, the material forms a second article 172 that corresponds substantially to the inner wall 131 of the internal cavity 129. It will be appreciated, however, that the pocket 141 may remain within the internal cavity 129.

Directionally solidifying the molten mass 136 in the outer member 130 forms the second article 172 as both of a single crystal structure and of substantially the same shape as the first article 116. Additionally, the second article 172 may densify and may be substantially free of voids, contaminates, or other defects. For example, when directionally solidifying the second article 172 using a starter seed or grain selector, contaminates in the molten mass 136 may be pushed, or collected, by the leading edge 148 into a common area of the second article 172, which may then be removed and scrapped.

Finally, with reference to FIG. 3, the method 1000 may continue to 1010, wherein post-processing of the second article 172 occurs as represented in FIG. 10. The second article 172 may be removed from the outer member 130 (e.g., by breaking the outer member 130 or otherwise removing the second article 172 from the outer member 130). Then, in some embodiments, the post-solidification device 151 may be used to remove the first portion 18 (i.e., the trim portion) of the second article 172 from the second body portion 24. Other post-processing may be performed, such as other cutting operations, polishing operations, and more.

It will be appreciated that the method 1000 and system 100 of the present disclosure increases manufacturing efficiency. A part (e.g., the part 10 of FIG. 1A, the part 10' of FIG. 1B, and/or the second article 172 of FIG. 10) may be formed that may have relatively complex features (e.g., three-dimensionally curved outer surfaces, etc.). Also, the part may have single crystal grain structure. Accordingly, the part may be included in a gas-turbine engine, and its single crystal grain structure may increase efficiency and/or increase the operating life of the engine.

Additionally, the part may be formed relatively quickly using the method 1000 and system 100 of the present disclosure. For example, the additive manufacturing represented in FIGS. 4 and 5 may be completed quickly because the outer wall 118 is formed additively, leaving the first article 116 hollow. However, the second group 113 of particles 110 remain within the cavity 120 of the first article 116 to be melted later during the manufacturing method 1000. Accordingly, instead of additively manufacturing the entire first article 116, the outer wall 118 is formed, saving manufacturing time.

The method 1000 and system 100 may also reduce manufacturing costs. For example, the cost of making mold tooling may be avoided. Also, costs associated with traditional casting (i.e., making a mold, dewaxing, and casting) may be avoided.

Additionally, the outer member 130 is unlikely to fracture or otherwise fracture during the method 1000. For example, even if there are different rates of thermal expansion between the outer member 130 and the material within the internal cavity 129, the outer member 130 is unlikely to fracture. This is because the first article 116 has relatively low density due to the loosely packed second group 113 of particles 110 within the first article 116. Accordingly, when the outer wall 118 and the second group 113 of particles 110 is melted into the molten mass 136 within the cavity 129, the material may melt and expand to a volume that is less than the volume of the internal cavity 129, leaving the pocket 141 remaining within the cavity 129.

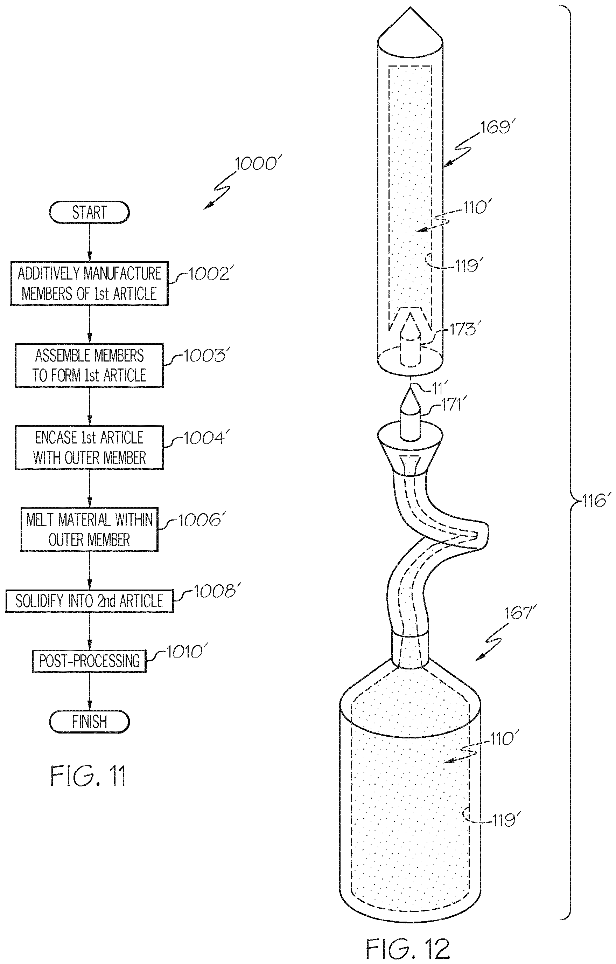

Referring now to FIG. 11 the method 1000' of manufacturing will be discussed according to additional embodiments of the present disclosure. It will be appreciated that the method 1000' may be substantially similar to the method 1000 discussed above with respect to FIG. 3. Thus, for the sake of brevity, features of the method 1000' that are common to the method 1000 will not be repeated.

The method 1000' may begin at 1002', wherein a plurality of members of the first article 116' are additively manufactured. Then, at 1003' the members may be assembled together to form the first article 116'. Subsequently, the method 1000' may proceed as described above. Specifically, at 1004' the assembled first article 116' may be encased with the outer member 130. Then, at 1006' the material within the outer member 130 is melted into the molten mass 136. Next, at 1008' the molten mass 136 is directionally solidified into the second article 172. Finally, post-processing may be performed at 1010' of the method 1000'.

Accordingly, the first article 116'may be assembled from a plurality of members (at 1002' and 1003'). For example, as shown in FIG. 12, a first member 167' and a second member 169' may be additively manufactured during the method 1000'. The first member 167' may correspond substantially to the first body portion 18 of FIG. 1A, and the second member 169' may correspond substantially to the second body portion 24 of FIG. 1A. In some embodiments, the first member 167' may include a cavity 119' that contains the particles 110' therein. Similarly, the second member 169' may include a cavity 199' that contains the particles 110' therein. Additionally, in some embodiments, the first member 167' may include a projection 171', and the second member 169' may include a receptacle 173'. The receptacle 173' may substantially correspond inversely to the projection 171'. Thus, once the first and second members 167', 169' are additively manufactured (at 1002' of the method 1000'), the first and second members 167', 169' may be assembled (at 1003' of the method 1000') by inserting the projection 171' into the receptacle 173'. Then the method 1000' may proceed as described above.

It will be appreciated that the method 1000' may provide certain benefits. For example, the first and second members 167', 169' may be additively manufactured simultaneously. This may reduce overall manufacturing time as compared to embodiments in which the first article is additively manufactured as a unitary, one-piece body. Also, by forming the first article from assembled members, it may be easier to form complex features (e.g., complex, three-dimensional curved surfaces, pockets, etc.) on the first article.

While at least one exemplary embodiment has been presented in the foregoing detailed description, it should be appreciated that a vast number of variations exist. It should also be appreciated that the exemplary embodiment or exemplary embodiments are only examples, and are not intended to limit the scope, applicability, or configuration of the present disclosure in any way. Rather, the foregoing detailed description will provide those skilled in the art with a convenient road map for implementing an exemplary embodiment of the present disclosure. It is understood that various changes may be made in the function and arrangement of elements described in an exemplary embodiment without departing from the scope of the present disclosure as set forth in the appended claims.

## Claims

1. A method (1000) of manufacturing a directionally solidified article (10) from an additively manufactured article comprising:
providing a collection of particulate material (108) that includes a first group (112) of particles and a second group (113) of particles (110);
additively manufacturing a first article (116), including forming an outer wall (118) from the first group (112) of particles layer-by-layer around the second group (113) of particles such that the outer wall (118) ultimately contains the second group (113) of particles within a cavity (120) defined by the outer wall (118), the second group (113) of particles remaining loosely packed within the cavity (120);
encasing, with an outer member (130), at least a portion of the outer wall (118) with the second group (113) of particles (110) loosely packed within the outer wall (118), the outer member (130) defining an internal cavity (129) that corresponds to the at least a portion of the outer wall (118);
heating the outer member (130) and the first article (116) to melt the outer wall (118) and the second group (113) of particles (110) together into a molten mass (136) within the internal cavity (129) of the outer member (130); and
solidifying, with a directional solidification device (138), the molten mass (136) along a predetermined solidification path within the outer member (130) to form a second article (172) that corresponds to at least a portion of the internal cavity (129) of the outer member (130).

2. The method of manufacturing of claim 1, wherein additively manufacturing the first article (116) includes forming the first article (116) to fully encapsulate the second group (113) of particles (110).

3. The method of manufacturing of claim 1, wherein encasing at least a portion of the first article (116) with the outer member (130) includes exposing the first article (116) to a slurry (128) of outer member material (127).

4. The method of manufacturing of claim 3, wherein the slurry of outer member material (127) is a ceramic material with a melting point above that of the first article (116).

5. The method of manufacturing of claim 1, wherein additively manufacturing the first article (116) includes additively manufacturing the first article (116) to include a first portion and a second portion;
wherein encasing the at least a portion of the first article (116) includes defining the internal cavity (129) to include a first volume that corresponds to the first portion of the first article (116) and a second volume that corresponds to the second portion of the first article (116);
wherein solidifying the molten mass (136) includes forming the second article (172) to include a body portion (24) that corresponds to the first volume and a trim portion (18) that corresponds to the second volume; and
further comprising removing the trim portion (18) from the body portion (24) after solidifying the molten mass (136).

6. The method of manufacturing of claim 5, wherein the trim portion (18) extends helically about an axis.

7. The method of manufacturing of claim 1, wherein additively manufacturing the first article (116) includes additively manufacturing a first member of the first article (116) and additively manufacturing a second member of the first article (116); and
further comprising assembling the first member and the second member to form the first article (116) before encasing the at least a portion of the first article (116) with the outer member (130).

8. The method of manufacturing of claim 1, wherein solidifying the molten mass (136) includes directionally solidifying the molten mass (136) to have a single-crystal structure.

9. The method of manufacturing of claim 1, wherein additively manufacturing the first article (116) includes forming the first article (116) to include a wall with a thickness between approximately 0.076 mm (0.003 inches) and approximately 0.79 mm (1/32 inches).

10. The method of manufacturing of claim 1, wherein encasing at least a portion of the first article (116) includes fully encasing the first article (116) with the outer member (130).

11. A manufacturing system for manufacturing a directionally solidified article from an additively manufactured article, the manufacturing system comprising:
an additive manufacturing device (102) having a support (106) that is configured to support a collection of particulate material (108) that includes a first group (112) of particles and a second group (113) of particles, the additive manufacturing machine (102) configured to additively manufacture a first article (116), including forming an outer wall (118) from the first group (112) of particles layer-by-layer around the second group (113) of particles such that the outer wall (118) ultimately contains the second group (113) of particles within a cavity (120) defined by the outer wall (118) , the second group (113) of particles remaining loosely packed within the cavity (120);
an encasement device (124) configured to form an outer member (130) about at least a portion of the outer wall of the first article (116) with the second group (113) of particles (110) loosely packed within the outer wall (118), the outer member (130) defining an internal cavity (129) that corresponds to the at least a portion of the first article (116);
a heating device (132) configured to heat the outer member (130) and the first article (116) to melt the outer wall (118) and the second group (113) of particles (110) together into a molten mass (136) within the internal cavity (129) of the outer member (130); and
a solidification device (132) configured to solidify the molten mass (136) along a predetermined solidification path within the outer member (130) to form a second article (172) that corresponds to at least a portion of the internal cavity (129) of the outer member (130).

12. The manufacturing system of claim 11, wherein the additive manufacturing device (102) is configured to additively manufacture the outer wall (118) to fully encapsulate the second group (113) of particles (110) within the cavity (120) of the first article (116).

13. The manufacturing system of claim 11, wherein the encasement device (124) is configured to fully encase the first article (116) with the outer member (130).

14. The manufacturing system of claim 11, wherein the solidification device is configured to solidify the molten mass (136) to have a single crystal structure.

15. The manufacturing system of claim 11, wherein additively manufacturing the first article (116) includes forming the outer wall (118) and the second group (113) of particles to have a predetermined porosity above 15%.

## Patentansprüche

1. Verfahren (1000) zur Fertigung eines gerichtet erstarrten Artikels (10) aus einem generativ gefertigten Artikel, umfassend:
Bereitstellen einer Sammlung von partikelförmigem Material (108), die eine erste Gruppe (112) von Partikeln und eine zweite Gruppe (113) von Partikeln (110) umfasst;
generatives Fertigen eines ersten Artikels (116), umfassend das Bilden einer Außenwand (118) aus der ersten Gruppe (112) von Partikeln Schicht für Schicht um die zweite Gruppe (113) von Partikeln herum, so dass die Außenwand (118) schließlich die zweite Gruppe (113) von Partikeln in einem durch die Außenwand (118) definierten Hohlraum (120) enthält, wobei die zweite Gruppe (113) von Partikeln lose gepackt in dem Hohlraum (120) verbleibt;
Umhüllen mindestens eines Abschnitts der Außenwand (118) mit der zweiten Gruppe (113) von Partikeln (110), die lose in der Außenwand (118) gepackt sind, mit einem äußeren Element (130), wobei das äußere Element (130) einen inneren Hohlraum (129) definiert, der dem mindestens einen Abschnitt der Außenwand (118) entspricht;
Erhitzen des äußeren Elements (130) und des ersten Artikels (116), um die Außenwand (118) und die zweite Gruppe (113) von Partikeln (110) zusammen zu einer geschmolzenen Masse (136) innerhalb des inneren Hohlraums (129) des äußeren Elements (130) zu schmelzen; und
Erstarren der geschmolzenen Masse (136) mit einer gerichteten Erstarrungsvorrichtung (138) entlang eines vorbestimmten Erstarrungsweges innerhalb des äußeren Elements (130), um einen zweiten Artikel (172) zu bilden, der mindestens einem Abschnitt des inneren Hohlraums (129) des äußeren Elements (130) entspricht.

2. Verfahren zur Fertigung nach Anspruch 1, wobei das generative Fertigen des ersten Artikels (116) das Bilden des ersten Artikels (116) umfasst, um die zweite Gruppe (113) von Partikeln (110) vollständig einzukapseln.

3. Verfahren zur Fertigung nach Anspruch 1, wobei das Umhüllen mindestens eines Abschnitts des ersten Artikels (116) mit dem äußeren Element (130) das Aussetzen des ersten Artikels (116) gegenüber einer Aufschlämmung (128) aus äußerem Elementmaterial (127) umfasst.

4. Verfahren zur Fertigung nach Anspruch 3, wobei die Aufschlämmung des äußeren Elementmaterials (127) ein keramisches Material mit einem Schmelzpunkt ist, der über demjenigen des ersten Artikels (116) liegt.

5. Verfahren zur Fertigung nach Anspruch 1, wobei das generative Fertigen des ersten Artikels (116) das generative Fertigen des ersten Artikels (116) umfasst, um einen ersten Abschnitt und einen zweiten Abschnitt zu umfassen;
wobei das Umhüllen des mindestens einen Abschnitts des ersten Artikels (116) das Definieren des inneren Hohlraums (129) umfasst, um ein erstes Volumen, das dem ersten Abschnitt des ersten Artikels (116) entspricht, und ein zweites Volumen, das dem zweiten Abschnitt des ersten Artikels (116) entspricht, zu umfassen;
wobei das Erstarren der geschmolzenen Masse (136) das Bilden des zweiten Artikels (172) umfasst, so dass er einen Körperabschnitt (24), der dem ersten Volumen entspricht, und einen Beschnittabschnitt (18), der dem zweiten Volumen entspricht, umfasst; und
ferner das Entfernen des Beschnittabschnitts (18) von dem Körperabschnitt (24) nach dem Erstarren der geschmolzenen Masse (136) umfasst.

6. Verfahren zur Fertigung nach Anspruch 5, wobei sich der Beschnittabschnitt (18) schraubenförmig um eine Achse erstreckt.

7. Verfahren zur Fertigung nach Anspruch 1, wobei das generative Fertigen des ersten Artikels (116) das generative Fertigen eines ersten Elements des ersten Artikels (116) und das generative Fertigen eines zweiten Elements des ersten Artikels (116) umfasst; und
ferner das Zusammenfügen des ersten Elements und des zweiten Elements umfasst, um den ersten Artikel (116) zu bilden, bevor der mindestens eine Abschnitt des ersten Artikels (116) mit dem äußeren Element (130) umhüllt wird.

8. Verfahren zur Fertigung nach Anspruch 1, wobei das Erstarren der geschmolzenen Masse (136) ein gerichtetes Erstarren der geschmolzenen Masse (136) umfasst, so dass sie eine Einkristallstruktur aufweist.

9. Verfahren zur Fertigung nach Anspruch 1, wobei das generative Fertigen des ersten Artikels (116) das Bilden des ersten Artikels (116) umfasst, so dass er eine Wand mit einer Dicke zwischen etwa 0,076 mm (0,003 Zoll) und etwa 0,79 mm (1/32 Zoll) umfasst.

10. Verfahren zur Fertigung nach Anspruch 1, wobei das Umhüllen mindestens eines Abschnitts des ersten Artikels (116) das vollständige Umhüllen des ersten Artikels (116) mit dem äußeren Element (130) umfasst.

11. Fertigungssystem zur Fertigung eines gerichtet erstarrten Artikels aus einem generativ gefertigten Artikel, wobei das Fertigungssystem umfasst:
eine Vorrichtung (102) zur generativen Fertigung mit einem Träger (106), der konfiguriert ist, um eine Sammlung von partikelförmigem Material (108) zu tragen, das eine erste Gruppe (112) von Partikeln und eine zweite Gruppe (113) von Partikeln umfasst, wobei die Maschine (102) zur generativen Fertigung konfiguriert ist, um einen ersten Artikel (116) generativ zu fertigen, umfassend das Bilden einer Außenwand (118) aus der ersten Gruppe (112) von Partikeln Schicht für Schicht um die zweite Gruppe (113) von Partikeln herum, so dass die Außenwand (118) schließlich die zweite Gruppe (113) von Partikeln innerhalb eines Hohlraums (120) enthält, der durch die Außenwand (118) definiert ist, wobei die zweite Gruppe (113) von Partikeln lose gepackt innerhalb des Hohlraums (120) verbleibt;
eine Umhüllungsvorrichtung (124), die konfiguriert ist, um ein äußeres Element (130) um mindestens einen Abschnitt der Außenwand des ersten Artikels (116) zu bilden, wobei die zweite Gruppe (113) von Partikeln (110) lose innerhalb der Außenwand (118) gepackt ist, wobei das äußere Element (130) einen inneren Hohlraum (129) definiert, der dem mindestens einen Abschnitt des ersten Artikels (116) entspricht;
eine Heizvorrichtung (132), die konfiguriert ist, um das äußere Element (130) und den ersten Artikel (116) zu erhitzen, um die Außenwand (118) und die zweite Gruppe (113) von Partikeln (110) zusammen zu einer geschmolzenen Masse (136) innerhalb des inneren Hohlraums (129) des äußeren Elements (130) zu schmelzen; und
eine Erstarrungsvorrichtung (132), die konfiguriert ist, um die geschmolzene Masse (136) entlang eines vorbestimmten Erstarrungsweges innerhalb des äußeren Elements (130) zu verfestigen, um einen zweiten Artikel (172) zu bilden, der mindestens einem Abschnitt des inneren Hohlraums (129) des äußeren Elements (130) entspricht.

12. Fertigungssystem nach Anspruch 11, wobei die Vorrichtung zur generativen Fertigung (102) konfiguriert ist, um die Außenwand (118) generativ zu fertigen, um die zweite Gruppe (113) von Partikeln (110) innerhalb des Hohlraums (120) des ersten Artikels (116) vollständig einzukapseln.

13. Fertigungssystem nach Anspruch 11, wobei die Umhüllungsvorrichtung (124) konfiguriert ist, um den ersten Artikel (116) vollständig mit dem äußeren Element (130) zu umhüllen.

14. Fertigungssystem nach Anspruch 11, wobei die Erstarrungsvorrichtung so konfiguriert ist, dass die geschmolzene Masse (136) so verfestigt wird, dass sie eine Einkristallstruktur aufweist.

15. Fertigungssystem nach Anspruch 11, wobei die generative Fertigung des ersten Artikels (116) das Bilden der Außenwand (118) und der zweiten Gruppe (113) von Partikeln umfasst, so dass diese eine vorbestimmte Porosität von über 15 % aufweisen.

## Revendications

1. Procédé (1000) de fabrication d'un article à solidification directionnelle (10) à partir d'un article fabriqué de manière additive comprenant :
la fourniture d'un ensemble de matière particulaire (108) qui comprend un premier groupe (112) de particules et un second groupe (113) de particules (110) ;
la fabrication additive d'un premier article (116), comprenant la formation d'une paroi extérieure (118) à partir du premier groupe (112) de particules, couche par couche, autour du second groupe (113) de particules, de sorte que la paroi extérieure (118) contienne finalement le second groupe (113) de particules à l'intérieur d'une cavité (120) définie par la paroi extérieure (118), le second groupe (113) de particules restant en vrac dans la cavité (120) ;
l'enveloppement, avec un élément extérieur (130), d'au moins une portion de la paroi extérieure (118) avec le second groupe (113) de particules (110) en vrac à l'intérieur de la paroi extérieure (118), l'élément extérieur (130) définissant une cavité interne (129) qui correspond à au moins une portion de la paroi extérieure (118) ;
le chauffage de l'élément extérieur (130) et du premier article (116) pour faire fondre la paroi extérieure (118) et le second groupe (113) de particules (110) ensemble en une masse fondue (136) à l'intérieur de la cavité interne (129) de l'élément extérieur (130) ; et
la solidification, avec un dispositif de solidification directionnelle (138), de la masse fondue (136) le long d'un chemin de solidification prédéterminé à l'intérieur de l'élément extérieur (130) pour former un second article (172) qui correspond à au moins une portion de la cavité interne (129) de l'élément extérieur (130).

2. Procédé de fabrication selon la revendication 1, dans lequel la fabrication additive du premier article (116) comprend la formation du premier article (116) pour encapsuler complètement le second groupe (113) de particules (110).

3. Procédé de fabrication selon la revendication 1, dans lequel l'enveloppement d'au moins une portion du premier article (116) avec l'élément extérieur (130) comprend l'exposition du premier article (116) à une suspension (128) de matériau d'élément extérieur (127).

4. Procédé de fabrication selon la revendication 3, dans lequel la suspension de matériau d'élément extérieur (127) est un matériau céramique avec un point de fusion supérieur à celui du premier article (116).

5. Procédé de fabrication selon la revendication 1, dans lequel la fabrication additive du premier article (116) comprend la fabrication additive du premier article (116) pour inclure une première portion et une seconde portion ;
dans lequel l'enveloppement de l'au moins une portion du premier article (116) comprend la définition de la cavité interne (129) afin d'inclure un premier volume qui correspond à la première portion du premier article (116) et un second volume qui correspond à la seconde portion du premier article (116) ;
dans lequel la solidification de la masse fondue (136) comprend la formation du second article (172) afin d'inclure une portion de corps (24) qui correspond au premier volume et une portion de garniture (18) qui correspond au second volume ; et
comprenant en outre le retrait de la portion de garniture (18) depuis la portion de corps (24) après solidification de la masse fondue (136).

6. Procédé de fabrication selon la revendication 5, dans lequel la portion de garniture (18) s'étend en hélice autour d'un axe.

7. Procédé de fabrication selon la revendication 1, dans lequel la fabrication additive du premier article (116) comprend la fabrication additive d'un premier élément du premier article (116) et la fabrication additive d'un second élément du premier article (116) ; et
comprenant en outre l'assemblage du premier élément et du second élément pour former le premier article (116) avant d'envelopper l'au moins une portion du premier article (116) avec l'élément extérieur (130).

8. Procédé de fabrication selon la revendication 1, dans lequel la solidification de la masse fondue (136) comprend la solidification directionnelle de la masse fondue (136) afin d'avoir une structure monocristalline.

9. Procédé de fabrication selon la revendication 1, dans lequel la fabrication additive du premier article (116) comprend la formation du premier article (116) afin d'inclure une paroi d'une épaisseur comprise entre environ 0,076 mm (0,003 pouce) et environ 0,79 mm (1/32 pouce).

10. Procédé de fabrication selon la revendication 1, dans lequel l'enveloppement d'au moins une portion du premier article (116) comprend l'enveloppement complet du premier article (116) avec l'élément extérieur (130).

11. Système de fabrication pour fabriquer un article à solidification directionnelle à partir d'un article fabriqué de manière additive, le système de fabrication comprenant :
un dispositif de fabrication additive (102) ayant un support (106) qui est conçu pour supporter un ensemble de matière particulaire (108) qui comprend un premier groupe (112) de particules et un second groupe (113) de particules, la machine de fabrication additive (102) étant conçue pour fabriquer de manière additive un premier article (116), comprenant la formation d'une paroi extérieure (118) à partir du premier groupe (112) de particules couche par couche autour du second groupe (113) de particules, de sorte que la paroi extérieure (118) contienne finalement le second groupe (113) de particules à l'intérieur d'une cavité (120) définie par la paroi extérieure (118), le second groupe (113) de particules restant en vrac à l'intérieur de la cavité (120) ;
un dispositif d'enveloppement (124) conçu pour former un élément extérieur (130) autour d'au moins une portion de la paroi extérieure du premier article (116) avec le second groupe (113) de particules (110) en vrac à l'intérieur de la paroi extérieure (118), l'élément extérieur (130) définissant une cavité interne (129) qui correspond à l'au moins une portion du premier article (116) ;
un dispositif de chauffage (132) conçu pour chauffer l'élément extérieur (130) et le premier article (116) afin de faire fondre la paroi extérieure (118) et le second groupe (113) de particules (110) ensemble en une masse fondue (136) à l'intérieur de la cavité interne (129) de l'élément extérieur (130) ; et
un dispositif de solidification (132) conçu pour solidifier la masse fondue (136) le long d'un chemin de solidification prédéterminé à l'intérieur de l'élément extérieur (130) pour former un second article (172) qui correspond à au moins une portion de la cavité interne (129) de l'élément extérieur (130).

12. Système de fabrication selon la revendication 11, dans lequel le dispositif de fabrication additive (102) est conçu pour fabriquer de manière additive la paroi extérieure (118) afin d'encapsuler complètement le second groupe (113) de particules (110) à l'intérieur de la cavité (120) du premier article (116).

13. Système de fabrication selon la revendication 11, dans lequel le dispositif d'enveloppement (124) est conçu pour envelopper complètement le premier article (116) avec l'élément extérieur (130).

14. Système de fabrication selon la revendication 11, dans lequel le dispositif de solidification est conçu pour solidifier la masse fondue (136) afin d'avoir une structure monocristalline.

15. Système de fabrication selon la revendication 11, dans lequel la fabrication additive du premier article (116) comprend la formation de la paroi extérieure (118) et du second groupe (113) de particules afin d'avoir une porosité prédéterminée supérieure à 15 %.
